# EUROPEAN PATENT APPLICATION

(11) **EP 3 309 224 A1**
(43) Date of publication of application: **18.04.2018**
(21) Application number: 17191848.5
(22) Date of filing: 19.09.2017
(51) Int. Cl.: C09D 11/00, B29C 67/00, C09D 11/101, G03F 7/00

(54) **INK COMPOSITION FOR USE IN 3D PRINTING**

(30) Priority: 11.10.2016 US 201615290320
(71) Applicant: Xerox Corporation, Rochester, NY 14644 (US)
(72) Inventor: CHOPRA, Naveen, Oakville, Ontario L6H 5W4 (CA); BAKHSHAEI, Baharak, North York, Ontario M3H 5C2 (CA); BRETON, Marcel P, Mississauga, Ontario L5K 2S6 (CA); SISLER, Gordon, St. Catharines, Ontario L2R 6P7 (CA); MOORLAG, Carolyn, Mississauga, Ontario L5G 4A7 (CA); JIDDAWI, Saleh, Vancouver, British Columbia V5P 2L7 (CA); LEE, Jonathan Siu-Chung, Oakville, Ontario L6H 4K4 (CA); ALLEN, C Geoffrey, Waterdown, Ontario L0R 2H5 (CA)
(74) Representative: Gill Jennings & Every LLP

(57) **Abstract**

An ink for use in 3D printing including at least one monomer, and an optional oligomer, and a photoinitiator, and the ink has a high glass transition temperature (Tg) and wide range of viscosity. The 3D ink composition, and embodiments, maintains a homogeneous and easily processed consistency when used in a multi-jet modeling printing process.

## Description

### BACKGROUND

Disclosed herein is an ink formulation suitable for use in printing such as three-dimensional (3D) printing. The ink formulation, in embodiments, is a radiation-curable ink composition that can be jetted in a printer, such as a 3D printer. The ink composition may be useful as a build material for multi-jet manufacturing (MJM). In further embodiments, the ink composition may comprise at least one acrylate monomer, acrylate oligomer, or prepolymer; and an optional photoinitiator.

3D printers are becoming increasingly popular in home and professional applications. There are many advantages to using 3D printers, including faster, more economical and high throughput prototype evaluation, with less associated waste. 3D printers currently offer a number of solutions for selective deposition modeling for professional use.

Methods of printing a 3D article or object are described herein. In some embodiments, a method of printing a 3D article comprises selectively depositing layers of a fluid build material to form the 3D article on a substrate or support, the build material comprising a build material described herein. A typical printing system applies an ultraviolet (UV) curable material to a non-curable wax support via inkjet. In some embodiments, a method of printing a 3D article comprises selectively depositing layers of a fluid build material to form the 3D article on a substrate or support, the build material comprising a build material described herein.

Further, additive manufacturing as practiced in industry has been, to date, mostly concerned with printing structural features using conventional curable UV inks when a MJM process is used. In the MJM process, liquid monomer is jetted onto a substrate layer by layer, interspersed with a curing step by UV light to build up a 3D object over time. Objects that have overhangs and complex architectures such as holes, mesh, and fine features require a support layer that is jettable, curable, and removable after the object has been formed.

While known compositions and processes are suitable for their intended purposes, a need remains for improved ink compositions with certain characteristics. Specifically, a need remains for build material ink compositions that provide improved jetting performance over a wide range of printing conditions and consistent and robust physical properties. There further remains a need for inks that possess homogeneous consistency prior and during ink jet deposition. There further remains a need for such inks can be applied digitally.

Thus, while previous ink compositions are suitable for their intended purpose, it is desired to have new material ink designs, and in embodiments, new photocurable ink compositions, to achieve both high resolution and functional properties.

### SUMMARY

In some aspects, embodiments herein relate to compositions useful in 3D printing, specifically a build material ink composition, which may comprise, for example, a mono functional acrylate monomer; at least one acrylate oligomer selected from the group consisting of a difunctional acrylate oligomer, multifunctional acrylate oligomer, and mixtures thereof; and a photoinitiator. In embodiments, the ink composition is substantially free of wax.

In some aspects, embodiments herein relate to radiation-curable compositions for use in 3D printing build material inks comprising a first mono functional acrylate monomer; a second mono functional acrylate monomer; at least one acrylate oligomer selected from the group consisting of a difunctional acrylate oligomer, a trifunctional acrylate oligomer, a tetrafunctional acrylate oligomer and multifunctional acrylate oligomer with functionality higher than tetrafunctional, and mixtures thereof; and a photoinitiator.

In some aspects, embodiments herein relate to compositions for use in 3D printing build material inks comprising a first mono functional acrylate monomer; a second mono functional acrylate monomer; at least one difunctional acrylate oligomer; at least one multifunctional oligomer; and a photoinitiator.

In some aspects, embodiments herein relate to a waxless radiation-curable ink composition for use in 3D printing comprising at least one monofunctional acrylate oligomer; an optional difunctional or multifunctional acrylate oligomer or mixtures thereof; and a photoinitiator; wherein said radiation-curable ink composition is substantially free of wax.

### BRIEF DESCRIPTION OF THE DRAWINGS

Various embodiments of the present disclosure will be described herein below with reference to the figures wherein:
FIG. 1 is a general reaction scheme for ultraviolet curing of acrylate-based build material compositions.
FIG. 2 is a graph showing the complex viscosity (y-axis, cps) vs. temperature (x-axis, °C) of selected build materials in accordance with the present disclosure.
FIG. 3 is a graph showing the storage modulus (E') (y-axis, MPa) vs. temperature (x-axis, °C) of selected build materials in accordance with the present disclosure.
FIG. 4 is a graph showing the loss modulus E" (y-axis, MPa) vs. temperature (x-axis, °C) of selected build materials in accordance with the present disclosure.
FIG. 5 is a graph showing the tan delta (y-axis) vs. temperature (x-axis, °C) of selected build materials in accordance with the present disclosure.

### DESCRIPTION

Disclosed herein is an ink formulation suitable for use in printing such as 3D printing. The ink formulation, in embodiments, is a radiation-curable ink composition that can be jetted in a printer, such as a 3D printer. The ink composition may be useful as a build material for MJM. In further embodiments, the ink composition may comprise at least one acrylate monomer, acrylate oligomer, or prepolymer; and an optional photoinitiator.

A method of printing a 3D article may comprise selectively depositing layers of an ink build material to form the 3D article on a substrate, the build material comprising a build material described herein.

The term "multifunctional oligomer" as used herein refers to an oligomer with functionality higher than a difunctional oligomer, and includes a trifunctional oligomer, tetrafunctional oligomer, and oligomers with functionality higher than that of a tetrafunctional oligomer.

The term "waxless" or "substantially free of wax" means that wax or wax compounds are not added to the ink composition during formulation and there are no more than trace amounts of wax or wax compounds in the final formulation.

The term "wax" means "an unctuous solid with varying degrees of gloss, slipperiness and plasticity, which melts readily," as defined in Industrial Waxes, Volumes 1 and 2; Chemical Publishing Company Inc., New York, NY (1975). A wax will generally display a well-defined transition temperature, and generally impart a transition of material properties of the ink at the transition temperature. A transition of material properties could be a sharp solid to liquid transition, and a composition free of wax will not undergo this type of dramatic transition. This could also be manifested by a sharp increase in viscosity once the ink is cooled from a molten state to below the melting point of the wax.

The term "radiation-curable" as used herein refers to the hardening or toughening of a polymeric composition via crosslinking of the functional groups of the ingredients of the composition wherein the curing process is activated by ultraviolet radiation. Curing may also be carried out via electron beam (EB) radiation, and in the case of electron beam radiation, crosslinking is initiated by radiation and may not require the use of a photoinitiator. Radiation cured compositions will be largely free of mobile components such as monomer or oligomer, and these initially mobile components have been crosslinked into the system bulk. Hardening or toughening coincides with crosslinking within the system bulk.

The monomers used herein may be, in embodiments, solventless. As used herein, "solventless" means "the absence of an organic solvent;" that is, organic solvents are not used to dissolve the monomer or oligomer components of the ink or are not used as the ink vehicle. However, it is understood that minor amounts of such solvents may be present in the resins as a consequence of their use in the process of forming the resin.

The terms "3D printing system," "3D printer," "printing," and the like generally describe various solid freeform fabrication techniques for making 3D objects by selective deposition, jetting, fused deposition modeling, and other techniques now known in the art or that may be known in the future that use a build material to fabricate the 3D object.

In one aspect, a build material described herein can be fluid at jetting temperatures encountered in 3D printing systems. In some embodiments, a build material solidifies by freezing once deposited on a surface during the fabrication of a 3D printed article or object. In other embodiments, a build material remains substantially fluid upon deposition on a surface during the fabrication of a 3D printed article or object and can be solidified by methods including curing such as by radiation curing by UV radiation or electron beam radiation, by thermal curing at elevated temperatures, or by chemical curing, and the like. In embodiments, the ink composition is waxless or substantially free of wax, and therefore, is not a phase change ink. Ink which is not a phase change ink will be in the liquid phase both prior to printing and during printing. Benefit of not using a phase change ink which is liquid prior to printing include ease of packaging the ink and transfer to the print machine prior to printing and ease of flow through the print machine prior to printing. Temperature requirements at the print head are also lower compared to phase change ink due to the ink already in the liquid phase upon meeting the print head, resulting in reduced energy use.

### Acrylate Monomer

The ink formulation herein may include at least one acrylate monomer. The acrylate monomer or oligomer may be monofunctional, difunctional oligomer, multifunctional oligomers (for example, tri-functional acrylate oligomers, tetra-functional acrylate oligomers, penta-functional acrylate oligomers, hexa-functional acrylate oligomers, and the like, and mixtures thereof), and the like, and combinations thereof may be used. Suitable acrylate monomers and oligomers include methacrylate, acrylate acid, aromatic acrylates such as phenyl acrylates, phenol acrylates, benzyl acrylates, and the like; ester acrylates such as polyester acrylates, acrylic acid esters, urethane acrylates, and the like, and mixtures or combinations thereof.

In embodiments, at least one monofunctional acrylate is present in the 3D ink build material. Examples of monofunctional acrylates include 2-phenoxyethylacrylate, alkoxylated lauryl acrylate, alkoxylated phenol acrylate, alkoxylated tetrahydrofurfuryl acrylate, caprolactone acrylate, cyclic trimethylolpropane formyl acrylate, ethylene glycol methyl ether methacrylate, ethoxylated nonyl phenol acrylate, isodecyl acrylate, isooctyl acrylate, lauryl acrylate, octadecyl acrylate (stearyl acrylate), tetrahydrofurfuryl acrylate (SR285, from Sartomer Chemical Co.), tridecyl acrylate, 4-acryolyl morpholine (from Aldrich Chemical Co.), tetrahydrofurfuryl methacrylate, 2-phenoxyethyl methacrylate, lauryl methacrylate, polypropylene glycol monomethacrylate, polyethylene glycol monomethacrylate, and tridecyl methacrylate allyl acrylate, allyl methacrylate, methyl (meth)acrylate, ethyl (meth)acrylate, n-propyl (meth)acrylate, n-butyl (meth)acrylate, isobutyl (meth)acrylate, n-hexyl (meth)acrylate, 2-ethylhexyl (meth)acrylate, n-octyl (meth)acrylate, n-decyl (meth)acrylate, n-dodecyl (meth)acrylate, 2-hydroxyethyl (meth)acrylate, 2- and 3-hydroxypropyl (meth)acrylate, 2-methoxyethyl(meth)acrylate, 2-ethoxyethyl (meth)acrylate, 2- or 3-ethoxypropyl (meth)acrylate, tetrahydrofurfuryl (meth)acrylate, 2-(2-ethoxyethoxy)ethyl acrylate, cyclohexyl methacrylate, glycidyl acrylate, and the like, and mixtures thereof. Specific examples of monoacrylate monomers include isobornyl acrylate (IBOA), commercially available from SARTOMER under the trade name SR 506, or from Evonik Industries under the trade name Visiomer® IBOA isobornyl methacrylate, commercially available from Sartomer under the trade name SR423A or from Evonik Industries under the trade name Visiomer® IBOMAnonyl phenol acrylate such as 2-[(butylamino) carbonyl] oxy] ethyl acrylate (Photomer 4184 reactive, non-yellowing diluent) from IGM Resins of BASF; and the like, and mixtures or combinations thereof. In embodiments, the monofunctional acrylate can act as a reactive diluent for oligomers.

In optional embodiments, at least one difunctional acrylate is present in the 3D ink build material. In some embodiments, difunctional acrylate, diacrylate and/or dimethacrylate include glycol acrylate oligomers, esters of aliphatic, cycloaliphatic or aromatic diols, including 1,3- or 1,4-butanediol, neopentyl glycol, 1,6-hexanediol, diethylene glycol, triethylene glycol, tetraethylene glycol, triethylene glycol dimethacrylate, cyclohexane dimethanol diacrylate, polyethylene glycol, tripropylene glycol, ethoxylated or propoxylated neopentyl glycol, 1,4-dihydroxymethylcyclohexane, 2,2-bis(4-hydroxycyclohexyl)propane or bis(4-hydroxycyclohexyl)methane, hydroquinone, 4,4'-dihydroxybiphenyl, bisphenol A, bisphenol F, bisphenol S, ethoxylated or propoxylated bisphenol A, ethoxylated or propoxylated bisphenol F or ethoxylated or propoxylated bisphenol S. Specific examples of difunctional acrylates include triethylene glycol diacrylate, commercially available from SARTOMER under the trade name SR 272 or triethylene glycol dimethacrylate, commercially available from Sartomer under the trade name SR 205, tetraethylene glycol diacrylate under the tradename SR268 (Tetra EGDA low volatility, difunctional acrylate) from Sartomer, Evonik or BASF; 1,12 dodecane diol diacrylate, 1,3-butylene glycol diacrylate, 1,4-butanediol diacrylate, 1,6-hexanediol diacrylate (SR238B, from Sartomer Chemical Co.), alkoxylated hexanediol diacrylate, alkoxylated neopentyl glycol diacrylate, cyclohexane dimethanol diacrylate, diethylene glycol diacrylate (SR230, from Sartomer Chemical Co.), ethoxylated (4) bisphenol A diacrylate (SR601, from Sartomer Chemical Co.), polyethylene glycol (400) diacrylate (SR344, from Sartomer Chemical Co.), propoxylated (2) neopentyl glycol diacrylate (SR9003B, from Sartomer Chemical Co.), tricyclodecane dimethanol diacrylate (SR833S, from Sartomer Chemical Co.), tripropylene glycol diacrylate or the like, and mixtures or combinations thereof.

In embodiments, a trifunctional acrylate or multifunctional oligomer may include glycol acrylate oligomers, 1,1-trimethylolpropane triacrylate, ethoxylated or propoxylated 1,1,1-trimethylolpropanetriacrylate, ethoxylated or propoxylated glycerol triacrylate, pentaerythritol monohydroxy triacrylate; ethoxylated trimethylolpropane triacrylate; polyester acrylates, urethane acrylates, polyester urethane acrylates such as Bomar BR 741 from Dymax, dipentaerythritol monohydroxy pentaacrylate or bis(trimethylolpropane) tetraacrylate, ethoxylated (9) trimethylol propane triacrylate, pentaerythritol triacrylate, propoxylated (3) glyceryl triacrylate (SR9020, from Sartomer Chemical Co.), propoxylated (3) trimethylol propane triacrylate (SR492, from Sartomer Chemical Co.), tris (2-hydroxylethyl) isocyanurate triacrylate (SR368, from Sartomer Chemical Co.), di-trimethylolpropane tetraacrylate, dipentaerythritol pentaacrylate (SR399, from Sartomer Chemical Co.), ethoxylated (4) pentaerythritol tetraacrylate (SR494, from Sartomer Chemical Co.), and the like, and combinations thereof. Urethane acrylates suitable for use in build materials described herein can be prepared in a known manner, typically by reacting a hydroxyl-terminated oligomeric urethane with acrylic acid or methacrylic acid to give the corresponding urethane acrylate or urethane methacrylate, or by reacting an isocyanate-terminated prepolymer with hydroxyalkyl acrylates or methacrylates to give the urethane acrylate or urethane methacrylate.

Oligomers may include polyester acrylates, polyether acrylates, epoxy acrylates, and urethane acrylates. Examples of polyester acrylate oligomers include: CN293, CN299, CN292, CN296, CN2279, CN2262, CN2267, CN2200, CN2203, CN2281, and CN2283 from Sartomer Chemical Co. Examples of polyether acrylate oligomers include: Genomer 3364, Genomer 3414, Genomer 3457, Genomer 3497, all available from Rahn Corp. Examples of epoxy acrylate oligomers include: CN104Z, CN2102E, CN110, CN120Z, CN116, CN117, CN118, CN119, and CN2003B, all available from Sartomer Chemical Co. Also, Genomer 2235, Genomer 2252, Genomer 2253, Genomer 2255, Genomer 2259, Genomer 2263, Genomer 2280, and Genomer 2281, all available from Rahn Corp. Examples of urethane acrylate oligomers include aromatic urethane oligomers such as: CN9782, CN9783, CN992, CN975 (hexafunctional), CN972, all available from Sartomer Chemical Co. Also, Genomer 4622 and Genomer 4217 (Rahn Corp.). Aliphatic urethanes include: CN9004, CN9005, CN9006, CN9006, CN9023, CN9028, CN9178, CN969, CN9788, CN986, CN989, CN9893, CN996, CN2920, CN3211, CN9001, CN9009, CN9010, CN9011, CN9071, CN9070, CN929, CN962, CN9025, CN9026, CN968, CN965, CN964, CN991, CN980, CN981, CN983, CN9029, CN9030, CN9031, CN9032, CN9039, CN9018, CN9024, CN9013 (all from Sartomer Chemical Co.). Also, Genomer 4188, Genomer 4215, Genomer 4230, Genomer 4267, Genomer 4269, Genomer 4312, Genomer 4316, Genomer 4425, Genomer 4590, Genomer 4690 (all from Rahn Corp.). Other examples of urethane acrylate oligomers include the Bomar™ series of urethane oligomers available from Dymax Corporation, such as: BR-441B, BR-471, BR704P, BR-741, BR-742P, BR-7432GI30, BR-744BT, BR742M, B-952, BR-116, BR-146, BR-202. Other examples from IGM Resins include Photomer 6008, Photomer 6010, Photomer 6019, Photomer 6019, Photomer 6184, Photomer 6630, and Photomer 6892.

In embodiments, the monofunctional acrylate monomers, difunctional oligomer, or tri- or higher multifunctional oligomer may be present in the ink in any desired or effective amount. In specific embodiments, the monofunctional acrylic monomer may be present in an amount of from about 20 to about 50 percent, or from about 25 to about 40 percent, or from about 30 to about 35 percent by weight, based on the total solids weight of the ink composition.

In embodiments, the optional difunctional acrylate oligomer may be present in the ink in any desired or effective amount. In specific embodiments, the difunctional acrylate oligomer may be present in an amount of from about 20 to about 60 weight percent, or from about 30 to about 50 percent, or from about 35 to about 40 percent, by weight, based on the total solids weight of the ink composition.

In embodiments, the optional trifunctional acrylate oligomer may be present in the ink in any desired or effective amount. In specific embodiments, the trifunctional acrylate oligomer may be present in an amount of from about 1 to about 25 percent, or from about 2 to about 20 percent, or from about 5 to about 10 percent by weight, based on the total solids weight of the ink composition.

In embodiments, the difunctional urethane oligomer is may be present in the ink in any desired or effective amount. In specific embodiments, the monofunctional acrylic monomer may be present in an amount of from about 20 to about 50 percent, or from about 25 to about 40 percent, or from about 30 to about 35 percent by weight, based on the total solids weight of the ink composition.

### Photoinitiator

The ink composition may optionally include an initiator, such as, for example, a photoinitiator. Such an initiator is desirable for assisting in curing of the ink. In embodiments, a photoinitiator that absorbs radiation, for example, UV light radiation of sufficient wavelength and intensity to create free radical species and initiate curing of the curable components of the ink may be used. In some embodiments of printing a 3D article, a layer of deposited build material is cured prior to the deposition of another or adjacent layer of build material.

Examples of suitable photoinitiators include known compounds and aromatic compounds such as benzophenones, benzoin ethers, benzyl ketals, α-hydroxyalkylphenones, α-alkoxyalkylphenones α-aminoalkylphenones and acylphosphine photoinitiators sold under the trade designations of IRGACURE® and DAROCUR® from BASF. Specific examples of suitable photoinitiators include 1-hydroxycyclohexyl-phenyl-ketone (available as BASF IRGACURE® IC-184); 2,4,6-trimethylbenzoyldiphenylphosphine oxide (available as BASF LUCIRIN® TPO); 2,4,6-trimethylbenzoylethoxyphenylphosphine oxide (available as BASF LUCIRIN® TPO-L); bis(2,4,6-trimethylbenzoyl)-phenyl-phosphine oxide (available as Ciba IRGACURE® 819) and other acyl phosphines; 2-methyl-1-(4-methylthio)phenyl-2-(4-morpholinyl)-1-propanone (available as BASF IRGACURE® 907) and 1-(4-(2-hydroxyethoxy)phenyl)-2-hydroxy-2-methylpropan-1-one (available as BASF IRGACURE® 2959); 2-benzyl 2-dimethylamino 1-(4-morpholinophenyl)-butanone-1 (available as BASF IRGACURE® 369); 2-hydroxy-1-(4-(4-(2-hydroxy-2-methylpropionyl)-benzyl)-phenyl)-2-methylpropan-1-one (available as BASF IRGACURE® 127); 2-dimethylamino-2-(4-methylbenzyl)-1-(4-morpholin-4-yl-phenyl)-butan-1-one (available as BASF IRGACURE® 379); titanocenes; isopropylthioxanthone; 1-hydroxy-cyclohexylphenylketone; benzophenone; 2,4,6-trimethylbenzophenone; 4-methylbenzophenone; diphenyl-(2,4,6-trimethylbenzoyl) phosphine oxide (available as BASF IRGACURE® IC-TPO); 2,4,6-trimethylbenzoylphenylphosphinic acid ethyl ester; oligo(2-hydroxy-2-methyl-1-(4-(1-methylvinyl)phenyl)propanone); 2-hydroxy-2-methyl-1-phenyl-1-propanone; benzyl-dimethylketal; and mixtures thereof. This list is not exhaustive, and any known photoinitiator that initiates the free-radical reaction upon exposure to a desired wavelength of radiation such as UV light can be used without limitation.

The photoinitiator may absorb radiation of about 200 to about 420 nanometers wavelengths in order to initiate cure, although use of initiators that absorb at longer wavelengths, such as the titanocenes that may absorb up to 560 nanometers, can also be used without restriction.

The photoinitiator can be present in any suitable or desired amount. In embodiments, the total amount of initiator included in the ink composition may be for example, from about 0.5 to about 15 percent by weight, or from about 1 to about 10 percent by weight, or from about 1 to about 5 percent by weight, based on the total solids weight of the ink composition.

### Colorant

The ink composition herein may also contain a colorant. Any suitable or desired colorant can be used in embodiments herein, including colorants, pigments, dyes, and the like and mixtures and combinations thereof.

Examples of suitable dyes include anionic dyes, cationic dyes, nonionic dyes, zwitterionic dyes, and the like, as well as mixtures thereof.

Examples of suitable pigments include black pigments, white pigments, cyan pigments, magenta pigments, yellow pigments, and the like, as well as mixtures thereof. Other pigments can also be selected, as well as mixtures thereof. The pigment particle size is desired to be as small as possible to enable a stable colloidal suspension of the particles in the liquid vehicle and to prevent clogging of the ink channels when the ink is used in a thermal ink jet printer or a piezoelectric ink jet printer.

The colorant can be present in the ink composition in any desired or effective amount, such as from about 0.05 to about 15 percent, or from about 0.1 to about 10 percent, or from about 1 to about 5 percent by weight, based on the total solids weight of the ink composition.

### Properties of Ink Composition

In embodiments, the 3D build material ink can be cured using UV light.

In embodiments, the 3D build material ink herein possesses a glass transition temperature (Tg) of from about 50 °C to about 140 °C, or from about 60 °C to about 130 °C, or from about 80 °C to about 120 °C.

In embodiments, the ink composition is a low-viscosity composition. The term "low-viscosity" is used in contrast to conventional high-viscosity inks such as screen printing inks, which tend to have a viscosity of at least 1,000 centipoise (cps). In specific embodiments, the ink disclosed herein has a viscosity from about 5 to about 20 cps, or from about 5 to about 15 cps, or from about 7 to about 10 cps measured at a temperature of 75 °C to 95 °C.

In embodiments, the 3D ink composition herein has a tensile storage modulus (E') at 70 °C of from about 100 to about 5000 MPa or from about 300 to about 2000 MPa, or from about 600 to about 1200 MPa.

In embodiments, the 3D ink composition herein has a tensile loss modulus (E") at 70 °C of from about 50 to about 3000 MPa or from about 80 to about 1000 MPa, or from about 100 to about 500 MPa.

In embodiments, the 3D ink composition herein has a tan delta maximum between from about 50 to about 100 °C or from about 60 to about 90 °C, or from about 75 to about 85 °C, and a loss tangent amplitude of from about 0.4 to about 0.8 or from about 0.5 to about 0.7 or from about 0.55 to about 0.65.

### Process for Preparing Inks

The ink compositions can be prepared by any suitable process, such as by simple mixing of the ingredients. One process entails mixing all of the ink ingredients together and filtering the mixture to obtain an ink. Inks can be prepared by mixing the ingredients, heating if desired, and filtering, followed by adding any desired additional additives to the mixture and mixing at room temperature with moderate shaking until a homogeneous mixture is obtained, in embodiments from about 5 to about 10 minutes. Alternatively, the optional ink additives can be mixed with the other ink ingredients during the ink preparation process, which takes place according to any desired procedure, such as by mixing all the ingredients, heating if desired, and filtering. In other embodiments, at least one difunctional or multifunctional (tri- or higher functional oligomer) are mixed together with stirring and optional heat, followed by mixing at least one monofunctional monomer, followed by optional filtration. Optionally, the monomers, difunctional and/or multifunctional oligomers can be added together in reverse sequence. In another embodiments, all the monomers and oligomers can, optionally, be added together prior to heat and filtration, or the monomers, difunctional and/or multifunctional oligomers can be added together in reverse sequence.

### Process for Use of Ink

Also disclosed herein is a process which comprises applying an ink composition as disclosed herein to a substrate in an imagewise pattern. The ink compositions can be used in a process which entails incorporating the ink composition into an ink jet printing or copying apparatus and causing droplets of the ink to be ejected in an imagewise pattern onto a substrate. In a specific embodiment, the printing apparatus employs a thermal ink jet process wherein the ink in the nozzles is selectively heated in an imagewise pattern, thereby causing droplets of the ink to be ejected in imagewise pattern. In another embodiment, the printing apparatus employs an acoustic ink jet process wherein droplets of the ink are caused to be ejected in imagewise pattern by acoustic beams. In yet another embodiment, the printing apparatus employs a piezoelectric ink jet process, wherein droplets of the ink are caused to be ejected in imagewise pattern by oscillations of piezoelectric vibrating elements. Any suitable substrate can be employed.

In a specific embodiment, the process entails printing the ink onto a deformable substrate, such as textile (e.g., synthetic or natural woven fabrics); ceramic (e.g., concrete, tile, or glass); rubber or rubber sheeting; plastic, plastic sheeting, thermoforming plastic, thermoplastic or the like; coated paper; metal or alloy sheeting, metal objects, or the like. In embodiments, the substrate is a plastic which is deformable at an elevated temperature higher than the glass transition temperature of the plastic, for example, in the process of molding into 3D objects. When the ink disclosed herein is used, the imagewise pattern will not be damaged upon molding.

In some embodiments, a composition comprises a 3D printed article comprising a build material as described herein and further comprising a support material. A support material can be used to support at least one layer of a build material during the 3D printing process and is able to be removed following the object printing process. In some embodiments, a 3D printed article described herein comprises a plurality of layers of the build material, wherein the layers of the build material are deposited according to data in a computer readable format. In some embodiments, at least one of the deposited layers of build material is supported by a support material. In some embodiments, the support material is removable to complete production of the 3D printed article or object.

In some embodiments, the layers of the build material are deposited according to an image of the 3D article in a computer readable format. In some embodiments, the build material is deposited according to preselected computer aided design (CAD) parameters.

In some embodiments, a preselected amount of build material described herein is heated to the appropriate temperature and jetted through the print head or a plurality of print heads of a suitable inkjet printer to form a layer on a build support platform in a build chamber. In some embodiments, each layer of build material is deposited according to the preselected CAD parameters. A suitable print head to deposit the build material, in some embodiments, is the Xerox Corporation piezoelectric Z850 print head. Additional suitable print heads for the deposition of build and support materials described herein are commercially available from a variety of ink jet printing apparatus manufacturers. For example, print heads available from Xerox or Ricoh may also be used in some embodiments.

In some embodiments comprising a method of printing a 3D article comprising a build material as described herein, the build material solidifies upon deposition. In some embodiments, the build material remains substantially fluid upon deposition. In some embodiments, the temperature of the build environment can be controlled so that the jetted droplets of build material increases in viscosity on contact with the receiving surface. In some embodiments, after each layer is deposited, the deposited material is planarized and cured with electromagnetic (e.g., UV) radiation prior to the deposition of the next layer. Optionally, several layers can be deposited before planarization and curing, or multiple layers can be deposited and cured followed by one or more layers being deposited and then planarized without curing. Planarization corrects the thickness of one or more layers prior to curing the material by evening the dispensed material to remove excess material and create a uniformly smooth exposed or flat up-facing surface on the support platform of the printer. In some embodiments, planarization prepared the layer of dispersed material to accept the next layer of material. In some embodiments, planarization is accomplished with a wiper device, such as a roller, which may be counter-rotating in one or more printing directions but not counter-rotating in one or more other printing directions. In some embodiments, the wiper device comprises a roller and a wiper that removes excess material from the roller. In some embodiments, the wiper device is heated. The process is continued until a useful finished 3D design is prepared. It should be noted that the consistency of the jetted build material disclosed herein prior to curing should be sufficient to retain its shape and not be subject to excessive viscous drag from the planarizer.

Moreover, a support material, in some embodiments, can be deposited in a manner consistent with that described herein for the build material. The support material, for example, can be deposited according to the preselected CAD parameters such that the support material is adjacent or continuous with one or more layers of the build material. Jetted droplets of the support material, in some embodiments, solidify or freeze on contact with the receiving surface. In some embodiments, the deposited support material is also subjected to planarization. Planarization of the support material may occur simultaneously to planarization of the build material. Interaction between build and support materials is such that no substantial distance gap between build and support material results due to material incompatibility during deposition, prior to curing, or following curing.

Layered deposition of the build material and support material can be repeated until the 3D article has been formed. In some embodiments, a method of printing a 3D article further comprises removing the support material from the build material. The support material can be removed by any means known to one of ordinary skill in the art and not inconsistent with the objectives of the embodiments herein.

Embodiments described herein are further illustrated in the following nonlimiting examples.

### Example 1

Ink compositions were prepared using the ingredients set forth in Table 1.

**Table 1. Summary of MJM Build Ink Compositions**

| | **Ex.1 (AB2606), CL1-05** | | **Ex. 2 (AB1152), CL3-01** | | **Ex. 3 (AB1183), CL4-01** | |
|---|---|---|---|---|---|---|
| | **%** | **m/g** | **%** | **m/g** | **%** | **m/g** |
| **SR506A (IBOA)** | 20.0 | 200 | - | - | 26.98 | 32.07 |
| **SR423A (IBOMA)** | - | - | 26.98 | 24.06 | - | - |
| **SR272 (TriEGDA)** | 30.0 | 100 | 16.89 | 15.06 | 16.89 | 20.07 |
| **SR268 (TetraEGDA)** | 10.0 | 100 | 9.69 | 8.64 | 9.69 | 11.51 |
| **SR368 (tris-2-hydroxyethylacrylate isocyanurate)** | - | - | 6.48 | 5.78 | 6.48 | 7.70 |
| **Photomer 4184** | 10.0 | 100 | 9.69 | 8.64 | 9.69 | 11.51 |
| **BR-741 (Bomar)** | 26.7 | 267 | 26.98 | 24.06 | 26.98 | 32.07 |
| **IC 184** | 3.0 | 30 | 3.00 | 2.68 | 3.00 | 3.57 |
| **IC TPO** | 0.3 | 3.0 | 0.30 | 0.27 | 0.30 | 0.36 |
| **TOTAL** | 100 | 1000 | 100 | 89.2 | 100 | 118.9 |

### Comparative Examples:

Comp. Ex.A A commercially available build ink (Objet 810)
Comp. Ex.B A commercially available build ink (Visijet CR-CL)

### General Procedure-Ink Preparation

To a 30mL amber glass bottle with a magnetic stir bar was added at least one oligomer, followed by at least one difunctional or multifunctional monomers (tri-functional or higher monomers). The material was allowed to stir on a Vario-Mag® heated stirring block at about 85 °C for about 20 minutes. After the materials were mixed to form a homogeneous liquid mixture, an optional additional monofunctional monomer and at least one photoinitiator was added, and mixing was continued for another approximately 30 minutes to furnish the final mixed ink.

Larger scale inks were prepared in a similar fashion using a 1 L glass beaker fitted with a glass-fiber heating mantle connected to a temperature controller and thermocouple. Mixing was achieved using a P3 overhead mixer. The ink was filtered through 1 um filter cloth (Parker).

### Example 2 - Comparative Examples

Samples of commercially available ink were purchased for comparative testing against the inventive ink. Comparative Example A is a commercially available build ink obtained from Objet Corporation and sold under the tradename "Objet 810." Comparative Example B is a commercially available build ink obtained from Visijet Corporation and sold under the tradename "Visijet CR-CL."

### Example 3

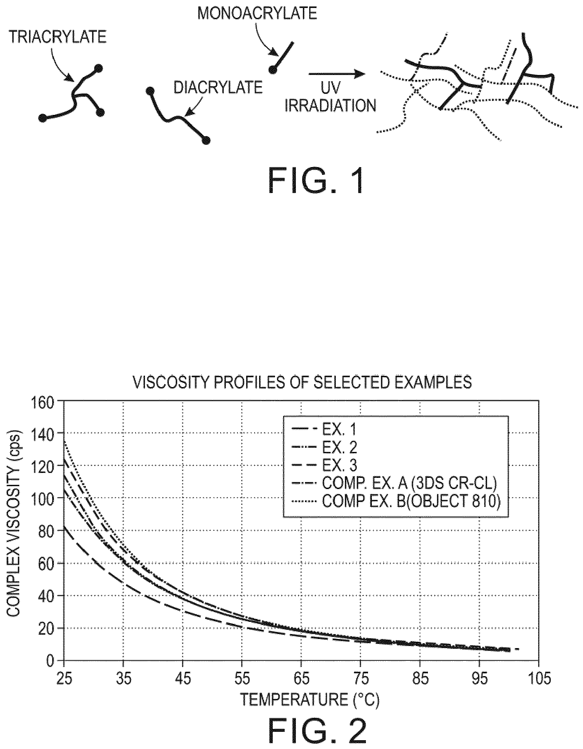

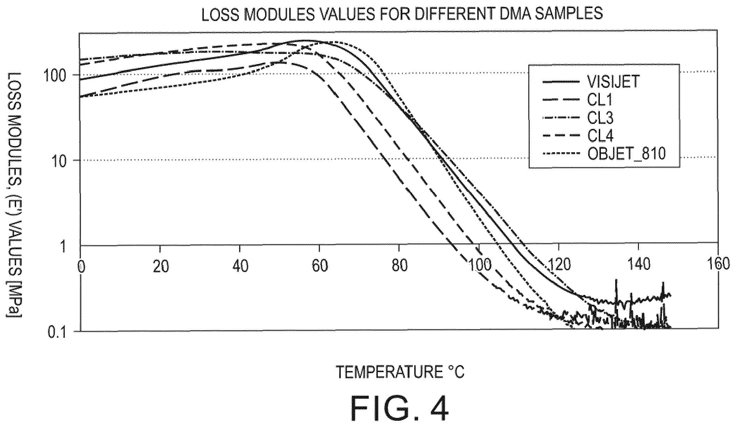

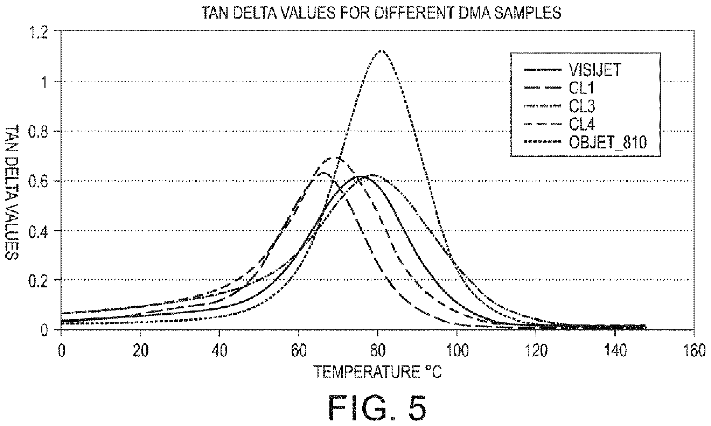

Testing of samples was accomplished and the results shown in FIGS. 2-5.

### Rheology

Samples were tested by measuring their complex viscosities over temperature using an Ares G2 rheometer equipped with a 25 mm Parallel plate and Peltier heating system. Samples of the inks were loaded on the rheometer at 102 °C, allowed to equilibrate, then swept over temperature to 25 °C at a rate of 1.5 °C/min at 10 rad/s. Viscosity data is shown in FIG. 2, which is a chart showing viscosity versus temperature.

### Ink Curing (thick mold)

A 1 cm x 6cm x 3cm silicone rubber mold was filled with the above respective formulations, and then subjected to LED curing for 14 seconds at 50% power, with a gap from lamp to substrate of 25.4 mm. The UV light was supplied by Phoseon RX Fireline 125 - 20 (dimension [mm]) 395nm (wavelength) 8W/cm² (Power). The cured part was removed from the mold and allowed to cool to room temperature between two stainless steel plates.

### Ink Curing (jetted)

Ink curing through jetting was carried out as follows: Firstly, ink was loaded into a reservoir set at a temperature of 85 °C. Drop mass is set to between 22 and 24 ng to ensure consistent jetting conditions between inks. The effective Vₚₚ values can vary between 32 and 38 Volts from ink to ink to ensure that the drop mass stays in the aforementioned range. Final printed DMA part dimensions average at approximately 60mm by 12.5mm by 3mm.

### DMA Plots

Comparative Samples were prepared by the thick mold method and tested through a DMA (Dynamic Mechanical Analysis) apparatus. The DMA Q800 (TA Instruments) applies a sinusoidal stress to the material while measuring the resulting strain. The frequency of the applied stress is generally set to 1 KHz and the temperature is ramped from -50 to 150 °C at a constant rate (3 °C/min or lower). From the stress/strain data, one can calculate the complex modulus (E*), and from it, one can extract the storage modulus, the loss modulus and the tangent of phase difference δ. The storage modulus is the elastic constituent of the material and can be related to material stiffness. The loss modulus is a measure of the viscous nature of the material. It can be related to the material ability to dissipate energy via molecular motion. The tangent delta is the ration of loss to storage modulus.

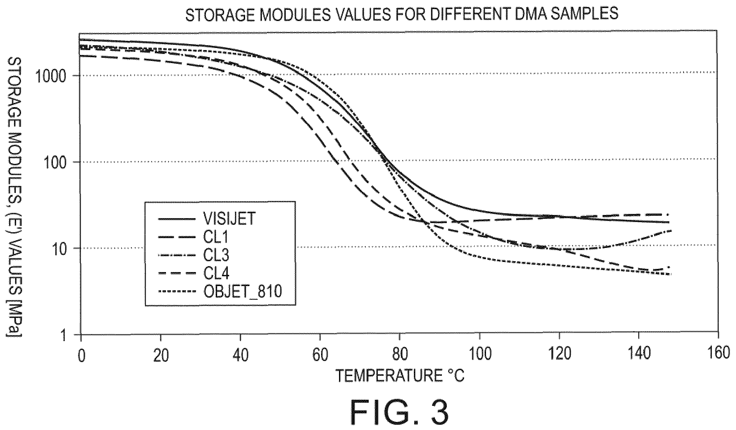

DMA plots of storage modulus, loss modulus and tan delta for the three inks and the two comparative examples are shown in FIGS. 3-5.

It is clear from the Examples and Comparative Examples that the inventive ink outperformed the comparative example inks and provided unexpectedly superior results over known comparative example inks owing to the higher temperature Tg (peak temperature of the tan delta maximum) and the lower amplitude of the peak tan delta. Both these results indicate a more robust material that is more resistant to dimensional change and breakdown at elevated temperatures typically encountered during post-processing (support removal).

The claims, as originally presented and as they may be amended, encompass variations, alternatives, modifications, improvements, equivalents, and substantial equivalents of the embodiments and teachings disclosed herein, including those that are presently unforeseen or unappreciated, and that, for example, may arise from applicants/patentees and others.

## Claims

1. An ink composition for use in 3D printing comprising:
at least one monofunctional acrylate monomer;
an optional oligomer selected from the group consisting of a difunctional acrylate oligomer, a multifunctional acrylate oligomer and mixtures thereof; and
a photoinitiator.

2. The composition of claim 1, wherein the monofunctional acrylate monomer is selected from the group consisting of 2-phenoxyethylacrylate, alkoxylated lauryl acrylate, alkoxylated phenol acrylate, alkoxylated tetrahydrofurfuryl acrylate, caprolactone acrylate, cyclic trimethylolpropane formyl acrylate, ethylene glycol methyl ether methacrylate, ethoxylated nonyl phenol acrylate, isobornyl acrylate, isodecyl acrylate, isooctyl acrylate, lauryl acrylate, octadecyl acrylate (stearyl acrylate), tetrahydrofurfuryl acrylate, tridecyl acrylate, and 4-acryolyl morpholine.

3. The composition of claim 1, wherein said oligomer comprises a difunctional acrylate oligomer.

4. The composition of claim 3, wherein said difunctional acrylate oligomer is a glycol acrylate oligomer.

5. The composition of claim 1, wherein said multifunctional acrylate oligomer is a trifunctional acrylate oligomer.

6. The composition of claim 5, wherein said trifunctional acrylate oligomer is a glycol acrylate oligomer.

7. The composition of claim 1, wherein said oligomer comprises an acrylate oligomer selected from the group consisting of a difunctional acrylate oligomer, a trifunctional acrylate oligomer, and mixtures thereof.

8. A radiation-curable ink composition for use in 3D printing comprising:
a first mono functional acrylate monomer;
a second mono functional acrylate monomer;
at least one acrylate oligomer selected from the group consisting of a difunctional acrylate oligomer, a trifunctional acrylate oligomer, a tetrafunctional acrylate oligomer and multifunctional acrylate oligomer with functionality higher than tetrafunctional, and mixtures thereof; and
a photoinitiator.

9. A build material ink composition for use in 3D printing comprising:
a first mono functional acrylate monomer;
a second mono functional acrylate monomer;
at least one difunctional acrylate oligomer;
at least one multifunctional oligomer; and
a photoinitiator.

10. A waxless ink composition for use in 3D printing comprising:
at least one monofunctional acrylate oligomer;
an optional difunctional or multifunctional acrylate oligomer or mixtures thereof; and
a photoinitiator;
wherein said radiation-curable ink composition is substantially free of wax.
